# EUROPEAN PATENT APPLICATION

(11) **EP 2 955 981 A1**
(43) Date of publication of application: **16.12.2015**
(21) Application number: 14172457.5
(22) Date of filing: 13.06.2014
(51) Int. Cl.: H05K 3/04, C23C 14/04, C23C 14/28, H05K 3/10

(54) **Method for manufacturing selective surface deposition using a pulsed radiation treatment**

(71) Applicant: Irepa Laser, 67400 Illkirch-Graffenstaden (FR); Asociacion de Investigacion Metalurgica del Noroeste - AIMEN, Torneiros (ES)
(72) Inventor: Bahouka, Armel, 67400 Illkirch Graffenstaden (FR); Otero, Nerea, 15008 A Coruna (ES); Romero, Pablo M., 36600 Villagarcia de Arosa (ES)
(74) Representative: Barny, Luc

(57) **Abstract**

The present invention relates to a method of manufacturing a direct and selective surface deposition by a pulsed radiation treatment. Said method allows the production of a selective pattern on any receiving material without any pre-treatment and/or post-treatment of said receiving material. The invention provides a selective deposition of a donor material onto a receiving material by means of a pulsed radiation treatment without any contact between said donor and receiving materials. It further provides a method of direct surface metallization of various types of receiving materials using a pulsed radiation treatment. The present invention provides a method of manufacturing a direct and selective surface deposition by a pulsed radiation treatment of a donor material onto a receiving material. The present invention relates more particularly to a method of manufacturing free form patterned deposition on surfaces of various receiving materials.

## Description

The present invention relates to a method of manufacturing a direct and selective surface deposition by a pulsed radiation treatment. Said method allows the production of a selective pattern on any receiving material without any pre-treatment and/or post-treatment of said receiving material. The invention provides a selective deposition of a donor material onto a receiving material by means of a pulsed radiation treatment without any contact between said donor and receiving materials. It further provides a method of direct surface metallization of various types of receiving materials using a pulsed radiation treatment. The present invention provides a method of manufacturing a direct and selective surface deposition by a pulsed radiation treatment of a donor material onto a receiving material. The present invention relates more particularly to a method of manufacturing free form patterned deposition on surfaces of various receiving materials.

Selective deposition of a donor material onto a receiving material is a main issue in several fields among which electronics, plastronics (combination of plastics engineering and electronics), photovoltaics, smart textile, sensors, printing, decoration, etc. If in some of said fields the deposition of a donor material has an ornamental objective, in the other fields technical sophistication and precision are required to ensure the mechanical and/or technical properties of the devices manufactured using the selective deposition method implemented. The prior art displays several methods in those various fields but most of them are time and material consuming. So there is still a need for a direct and selective method of deposition of a donor material on a receiving material.

As an example in the field of plastronics, the development of communications needs and sophisticated miniaturized devices requires the manufacturing of internal circuitries that are also miniaturized and displaying increasing technical capacities. Each circuit obeys to a specific set of requirements attached to the final uses and operating conditions. The available techniques can provide for such miniaturized devices and circuitries using several manufacturing ways and techniques such as Laser Direct Structuring (LDS) and the method described in the US patent application US 2013/0126465. These two methods generally include several steps of pre-treatment of the receiving material in order to incorporate the metallic compounds and to activate them by means of laser beam or by chemical agents. The surfaces are also mechanically, chemically etched to degrease them and to increase their bonding capacities with the deposited material by modifying for instance their porosity and/or their hydrophilic properties. The deposition process being a metallization process can include sputtering or plastic water plating. Further steps can be the photoresist coating and shadow masking processes. The above-described methods have the disadvantage of requiring pre-treatment steps and the use of chemical agents. Moreover, the metallization is not a direct deposition since the patterned circuit needs to be developed. All of those disadvantages are time consuming and cost in complicated processes.

In the field of photovoltaics one main issue is the selective or whole plate metallization of silicon wafers surface for manufacturing solar cells. The prior art describes several methods for the deposition of metal onto a silicon wafer such as screen-printing with aluminum pastes or inkjet structured with evaporated aluminum metallization. Most of them imply several steps among which pre-treatment(s) and/or post-treatment(s) of the receiving material or the contact between the donor and the receiving materials.

The European patent EP2064748 describes a method for metalizing semi-conductors in the field of silicon based solar cells. The donor is an aluminium foil and the energy source is a laser beam. Said patent describes a method where a direct contact between the aluminium foil and the silicon board is required, preferably said foil is pressed on the receiving material. In one embodiment said method is implemented in a liquid phase or using a sacrificial layer to optimize the deposit of the aluminium on the silicon board. It is mandatory that the aluminum foil be in intimate contact with the silicon board for the laser beam to be efficient since if the foil is not in close contact the laser beam will perforate the foil. So this method requires a close contact between the donor and receiving material, even a pressing stage, and a post-treatment of the device being manufactured. This is not a direct and selective method of metallization of aluminium on a silicon receiving material but a material and time-consuming method.

The European patent application EP1179288 describes a method for direct material deposition on a substrate, said method comprising passing one or more feedstocks through a laser beam under conditions sufficient to convert substantially all of said feedstock into a depositable form and depositing said feedstock on said substrate. The feedstock is finely divided in particles. This invention combines the precision spray process with in-flight laser treatment in order to produce direct write electronic components. In addition to these components, the process can lay down lines of conductive, inductive, and resistive materials. This combined techniques are limited to donor materials in particular form (in order to be sprayed) and involves several steps, so this is a material and time consuming method.

The European patent EP1191127 describes a process for metallizing dielectric materials where the dielectric material is adhesively covered with an activating layer consisting of conductive material and the structuring of the activating layer is carried out by a subsequent laser treatment. The dielectric is made of plastic and/or ceramic. The activating layer is made of a conducting polymer. The conducting polymer has a thin metal layer. This method is applied in the field of electronics for the production of printed circuit boards. This method has several drawbacks among which several steps to be implemented, a treatment of the receiving material and the use of several products. Consequently this method is not a direct and selective deposition method.

The European patent application EP1241279 describes a method for the metallization of a substrate comprising the steps of a) coating the substrate with a layer of a precursor composite material made up of a polymer matrix doped with dielectric particles of a photo-reducing material; b) irradiating the surface to be metallized with a laser beam; and c) immersing the irradiated component in an autocatalytic bath containing metal ions which are deposited on the irradiated surface. This method implies several steps and a treatment of the receiving material. This is not a direct and selective deposition method.

The European patent EP1268211 provides a printing method for the transfer of printing substances, from a colour support onto a printing substrate, whereby the printing substance undergoes a volume- and/or position-change, by means of an induced process of an energy-releasing device and, thus, the transfer of a printed point, onto the printing substrate occurs. The printing substance, ink, is coated on the colour support, forming an essentially complete film. The process implies that ink is transferred into an exchange material and then from the exchange material onto the printing substrate. This method implies the use of an exchange material and this is not a direct and selective deposition method.

The European patent application EP0602146 describes a method for surface metallizing of plastics, typically polymeric components, where firstly a bonding sublayer is formed in the supporting surface by depositing an organometallic substance, preferably iron acetylacetonate, and exposing it to a laser beam, whereafter the metal layer is chemically and/or electrochemically deposited on said bonding sublayer in a conventional manner according to the prior art. This method implies several treatments of the receiving material. This is not a direct and selective deposition method.

Considering the above described prior art, there is still a need for a direct and selective method of deposition of a donor material on a receiving material that needs no pre-treatment or post-treatment of said receiving material, no graving step (chemical, mechanical, galvanometric or by means of pulsed radiation, etc.), no activation step and involves no use of chemicals or pastes for functionalising and/or patterning the surface of the receiving material.

The present invention provides a method of manufacturing a direct and selective surface deposition by a pulsed radiation treatment of a donor material onto a receiving material. The present invention relates more particularly to a method of manufacturing free form patterned deposition on surfaces of various receiving materials. In particular embodiments, the method according to the invention provides a method of manufacturing free form patterned metallization on surfaces of receiving materials such as semi-conductors, plastics, polymers, textiles, papers, glasses, woods or metals. According to the present invention, the donor is in solid state and can have the shape of a foil or a wire, said foil or wire can be metallic or not, electrically conductive or not. The donor according to the present invention can also be a gel film or a ribbon. The process enables the rapid deposition of the donor material on the receiving material, in one step, without any prior specific preparation of the receiving material, without any direct close contact between said donor and receiving materials and without any post-treatment of the receiving material after deposition.

The present invention is directed to a method of manufacturing a direct and selective surface deposition of a donor material onto a receiving material by a pulsed radiation treatment consisting of the following steps:
a) selecting a donor material in a solid state
b) selecting a receiving material able to receive a pulsed radiation treatment deposition,
c) selecting an adapted pulsed radiation treatment that can both transfer the donor material onto the receiving material and in the meantime that can preserve the integrity of said receiving material,
d) placing the donor material in a solid state on a spacer placed on the receiving material, without any contact between said donor and receiving material,
e) applying the pulsed radiation of c) on the donor material in a solid state to transfer the donor material on the receiving material surface.

The method according to the invention implies that the donor material is placed and maintained in position on the receiving material using a spacer having a chosen size. The space between the donor and receiving material is controlled and chosen according to the receiving material and the deposit to be made. A device providing the pulsed radiation allows the control of the positioning, energy, programmed speed, overlapping, etc. of said pulsed radiation. When the donor material goes through the pulsed radiation, the irradiated area changes from a solid state to a liquid state and comes away from the solid donor, e.g. the foil, wire, gel film or ribbon. The donor material in a liquid state cools within the flight distance between the solid donor and the receiving material. When contacting the receiving material, it still cools, what allows the donor material to be long term fixed on the surface of the receiving material. The time interval between the pulsed radiation and the deposition is about a microsecond. The donor material displays no chemical change but only a change in its state from solid to liquid and then back to solid.

With regards to the pulsed radiation system, its parameters and in particular those linked to energy, overlapping, scan programmed speed, will help the donor material to be transformed and deposited in a free form as wanted. The pulsed radiation system can be a laser system with positioning means. The programmed pattern is chosen according to the chosen donor and receiving materials. The laser beam is focalized at the optimal distance to get the best deposit regarding the programmed pattern. In one embodiment, the pulsed radiation system is a laser system. The pulsed radiation system can also be an electron beam system with positioning means. When the pulsed radiation system is a laser system several key parameters have to be controlled among which the wavelength, the fluence, the pulse rate, the focus and the pulse duration. The wavelength is typically from 300 nm to 10 microns depending on the reflectivity of the chosen donor material. The fluence is typically from 10 to 100 J/cm2 and impacts the shock wave created and the maximal speed reached by the whole process as well as the temperature of the transferred material and physic-chemical processes during the transfer. The pulse rate is typically from 1 kHz to 2 MHz and impacts the energy given to the donor (too much energy can lead to donor and/or receiving material degradation). The laser beam is typically focusing on the surface of the receiving material and impacts the way the matter-light interaction evolves according to the thickness of the donor and receiving materials. Finally the pulse duration if from femtosecond to microsecond and impacts on the transfer physics, the thermal energy and the final characteristics and properties of the deposited material. In one embodiment of the present invention the pulsed radiation system is selected from a laser system and an electron beam system.

According to the present invention, the solid donor material can be a foil, a wire, a gel film or a ribbon. The solid donor can be metallic or not and electrically conductive or not. It thickness is in relation with the desired thickness of donor material to be deposited on the receiving material and can be down to 1 µm especially with regards to implementation of the present invention in the fields of plastronics and photovoltaics. In a particular embodiment the donor material according to the present invention is in the shape of a foil, a wire, a gel film or a ribbon. In yet another embodiment, the donor material has a thickness down to 1 µm.

The solid donor material can be a plastic/polymer, a metal or a metal alloy, a biological material (such as a protein-based or DNA foil or patch), a graphene or silicon carbide sheet. The solid donor material can be selected from aluminium or aluminium alloys, bismuth or bismuth alloys, chromium or chromium alloys, cobalt or cobalt alloys, coper or copper alloys, gallium or gallium alloys, gold or gold alloys, indium, iron or iron alloys, lead or lead alloys, magnesium or magnesium alloys, mercury or mercury alloys, nickel or nickel alloys, potassium or potassium alloys, silver or silver alloys, sodium or sodium alloys, titanium or titanium alloys, tin or tin alloys, zinc or zinc alloys, zirconium or zirconium alloys and graphene or graphene related materials.

According to the present invention when the donor material is a plastic and/or a polymer it is a plastic or polymer selected from polyethylene terephthalate (PET), polymethylmethacrylate (PMMA), polyamide (PA), polyhexamethylene adipamide (PA6/6), polycarbonates (PC), the polymer obtained by polymerizing a N,N-dimethylacrylamide monomer with a vinyl-type silane (PDMA), sheet molding compound (SMC), polydimethylsiloxane (PDMS) or silicon, Polypropylene (PP), ethylene vinyl acetate copolymer (EVA), Poly(Acrylonitrile Butadiene Styrene) (ABS), Polyoxymethylene (POM), polystyrene (PS), liquid crystal polymer (LCP), polypropylene (PP), or any other plastic/polymer material. These plastics or polymers can be manufactured by injection molding or extrusion molding a material selected from the group consisting of polyethylene (PE), polystyrene (PS), polycarbonate (PC), acrylonitrile butadiene-styrene (ABS), polyethylene terephthalate (PET), polybutylene terephthalate (PBT), liquid crystal polymers (LCP), polyamide (PA), nylon, polyoxymethylene (POM), polypropylene (PP), extruded or injected fiberglass, and any composites thereof.

In a particular embodiment the solid donor material is selected from a plastic or a polymer. In a preferred embodiment the solid donor material is selected from a metal or a metal alloy. In yet another preferred embodiment the solid donor material is selected from aluminium or aluminium alloys, bismuth or bismuth alloys, chromium or chromium alloys, cobalt or cobalt alloys, copper or copper alloys, gallium or gallium alloys, gold or gold alloys, indium, iron or iron alloys, lead or lead alloys, magnesium or magnesium alloys, mercury or mercury alloys, nickel or nickel alloys, potassium or potassium alloys, silver or silver alloys, sodium or sodium alloys, titanium or titanium alloys, tin or tin alloys, zinc or zinc alloys, zirconium or zirconium alloys and graphene and graphene related materials. In a preferred embodiment the donor is aluminium.

The receiving material surface can be planar or three-dimensional. The thickness of said receiving material is not important for the implementation of the present invention. Nevertheless said thickness can be down to 1 µm. Moreover the receiving material can be metallic or not, electrically conductive or not and thermically conductive or not. The receiving material is selected from semi-conductors (silicium, germanium, gallium arsenide, etc.), plastics or polymers (PET, PMMA, PA, PC, PDMA), textiles, glasses (borosilicate, tempered, tinted, soda-lime, etc.), papers, graphene and graphene related material, ceramics, woods, silicon carbide and any related material, acetates or Nafion®. Consequently in one embodiment the receiving material has a planar or a three-dimensional surface to receive the donor deposition. In yet another embodiment the receiving material is selected from semi-conductors, plastics or polymers, textiles, glasses, papers, graphene, ceramics, acetates or Nafion®, graphene and graphene related materials.

In the present invention, the plastic or polymer receiving material can be made of polyethylene terephthalate (PET), polymethylmethacrylate (PMMA), polyamide (PA), polyhexamethylene adipamide (PA6/6), polycarbonates (PC), the polymer obtained by polymerizing a N,N-dimethylacrylamide monomer with a vinyl-type silane (PDMA), sheet molding compound (SMC), polydimethylsiloxane (PDMS) or silicon, Polypropylene (PP), ethylene vinyl acetate copolymer (EVA), Poly(Acrylonitrile Butadiene Styrene) (ABS), Polyoxymethylene (POM), polystyrene (PS), liquid crystal polymer (LCP), polypropylene (PP), or any other plastic/polymer material. These plastics or polymers can be manufactured by injection molding or extrusion molding a material selected from the group consisting of polyethylene (PE), polystyrene (PS), polycarbonate (PC), acrylonitrile butadiene-styrene (ABS), polyethylene terephthalate (PET), polybutylene terephthalate (PBT), liquid crystal polymers (LCP), polyamide (PA), nylon, polyoxymethylene (POM), polypropylene (PP), extruded or injected fiberglass, and any composites thereof. In a preferred embodiment the receiving material consists of silicon, silicon related materials and silicon oxides. In a particularly preferred embodiment the receiving material consists of silicon.

In one embodiment of the method according to the present invention the donor material, the spacer and the receiving material are hold by a mechanical clamping system. Said clamping system can be of any nature such as a mechanical holder, a magnetic holder or an electromechanical holder. In a preferred embodiment the clamping system is a mechanical holder.

In a preferred embodiment, the method according to the invention is directed to a method of manufacturing a direct and selective surface deposition of a metal donor material onto a receiving material by a pulsed radiation treatment consisting of the following steps:
a) selecting a metal donor material in a solid state,
b) selecting a receiving material able to receive a pulsed radiation treatment deposition,
c) placing the metal donor material in a solid state on a spacer placed on the receiving material,
d) providing a pulsed radiation system able to transfer the metal donor material onto the receiving substrate material surface without any contact between said donor and receiving material,
e) applying the pulsed radiation of d) on the donor material in a solid state to transfer the metal donor material on the receiving material.

The solid metal donor material is selected from aluminium or aluminium alloys, bismuth or bismuth alloys, chromium or chromium alloys, cobalt or cobalt alloys, copper or copper alloys, gallium or gallium alloys, gold or gold alloys, indium, iron or iron alloys, lead or lead alloys, magnesium or magnesium alloys, mercury or mercury alloys, nickel or nickel alloys, potassium or potassium alloys, silver or silver alloys, sodium or sodium alloys, titanium or titanium alloys, tin or tin alloys, zinc or zinc alloys, zirconium or zirconium alloys, graphene and its related materials or silicone carbide and its related materials.

The invention further provides the use of laser as a pulsed radiation system during the above described metallization method. Consequently, the present invention is directed to a method of manufacturing a direct and selective surface metallization onto a receiving material by a laser-assisted treatment consisting of the following steps:
a) selecting a metal donor material in a solid state,
b) selecting a receiving material able to receive a laser-assisted deposition,
c) selecting a laser system that can both transfer the metal donor onto the receiving material and in the meantime that can preserve the integrity of the receiving material,
d) placing the metal donor material in a solid state on a spacer placed on the receiving material without any contact between said donor and receiving material,
e) applying the laser system of c) on the donor material in a solid state to transfer the metal donor material on the receiving material.

In yet another embodiment, the invention provides the use of laser as a pulsed radiation system during the above described metallization method where the solid metal donor has a particular melting point. During the various experiments, particularly interesting results were obtained with metal donor material having a melting point higher than 55°C. Consequently, the present invention is also directed to a method of manufacturing a direct and selective surface metallization onto a receiving material by a laser-assisted treatment consisting of the following steps:
a) selecting a metal donor material in a solid state with a melting point higher than 55°C,
b) selecting a receiving material able to receive a pulsed radiation treatment deposition,
c) selecting a laser system that can both transfer the donor material onto the receiving material and in the meantime that can preserve the integrity of said receiving material,
d) placing the metal donor material in a solid state on a spacer placed on the receiving material without any contact between said donor and receiving material,
e) applying the laser beam of c) on the donor material in a solid state to transfer the donor material on the receiving material surface.

The present invention is illustrated and detailed by figures 1 to 7. Said figures relate to experiments and results that will be discussed in the example part. Said figures relate to a metallization process using aluminium as a donor material and silicon wafers as receiving material.
Fig. 1 shows a laser pulsed radiation beam (1) delivered by a pulsed radiation system according to the invention. The donor material (3) is an aluminium foil and the receiving material (4) is a silicon wafer. The area (2) evolves from state a) to state b) further to the pulsed radiation beam and as a result, a part of the donor material (5) is deposited on the receiving material (4). There is a direct transfer of the donor material (3) that is deposited on the receiving material (4).
Fig. 2 shows Rsheet measurements of mono and poly crystalline square shaped samples according to the power used.
Fig. 3 shows Rsheet values versus power measured on square shaped metallized poly-crystalline silicon wafers.
Fig. 4 shows the EDX composition on square aluminium transferred on a mono silicon wafer and also a picture of it and finally SEM details of it.
Fig. 5 shows in a) a black coating of a receiving material, b) structural detail of the black coating represented in a), c) and d) are further details representing the structure of the deposited material.
Fig. 6 shows a SEM representation of the vicinity of aluminium transfer in shape of a cross on a poly-silicon wafer.
Fig. 7 shows a SEM representation of aluminium lines on a mono-silicon wafer.

The above detailed figures are only illustrative of an embodiment of the present invention and are not to be interpreted as limitative.

An application of the method according to the invention is manufacturing plastic and/or polymers metallized circuit, so that a circuit structure can be formed on any plastic and/or polymer receiving material. Moreover a metal circuit layer of the desired circuit can be optionally formed on any one or more surfaces of the plastic and/or polymer receiving material to achieve patterned circuit arrangements, which can be applied to a variety of differently configured structures, such as antennas, light-emitting diode (LED) carriers, circuit boards, connectors, electronic devices, steering wheels and the like. Consequently the present invention is directed to a method of manufacturing a direct and selective surface deposition of a metal donor material onto a receiving material by a pulsed radiation treatment consisting of the following steps:
a) selecting a metal donor material in a solid state,
b) selecting a plastic and/or polymer receiving material with a thickness down to 5 µm and able to receive a pulsed radiation system treatment,
c) selecting a pulsed radiation system able to transfer the metal donor material onto the receiving material surface and in the meantime that can preserve the integrity of said receiving material,
d) placing the metal donor material in a solid state on a spacer placed on the receiving material without any contact between said donor and receiving material,
e) applying the pulsed radiation of c) on the donor material in a solid state to transfer the metal donor material on the receiving material.

Another application of the method according to the invention is manufacturing smart textiles by creating metallic circuitries on textiles. In this particular embodiment the receiving material is a textile that will not be damaged by the pulsed radiation treatment (e.g. polyaramide or polyamide) during the deposition of the donor material. Consequently the present invention is directed to a method of manufacturing a direct and selective surface deposition of a metal donor material onto a textile receiving material by a pulsed radiation treatment consisting of the following steps:
a) selecting a metal donor material in a solid state,
b) selecting a textile receiving material with a thickness down to 5 µm,
c) selecting a pulsed radiation system able to transfer the metal donor material onto the textile surface and in the meantime that can preserve the integrity of said receiving textile,
d) placing the metal donor material in a solid state on a spacer placed on the textile without any contact between said donor and textile material,
e) applying the pulsed radiation of c) on the donor material in a solid state to transfer the metal donor material on the textile.

A suitable textile according to the above-mentioned embodiment is typically cotton or any cotton mixture, whool or any whool mixture, synthetic textile or any synthetic textile mixture, neoprene, or pretreated material such as Gore-Tex®.

Another application of the method according to the invention is manufacturing sensors. In this particular embodiment the receiving material is of any type and the process is a metallization process meaning that the donor material is a metal or a metal alloy. In the particular case of µ-chips sensors the metallization process according to the invention can provide electrodes, circuits and contacts. The receiving materials are then selected from silicon, silicon oxides, semi-conductors like AsGa or others in III-V band, graphene, graphene related materials. The donor materials are selected from metals like aluminium, gold or any other suitable electrically conductive material.

Another application of the method according to the invention is the bio-printing of biological material. In this particular embodiment the receiving material is a biological material that will not be damaged by the pulsed radiation treatment during the deposition of the donor material. The donor material can be DNA or a protein foil as examples. In the case of implementation of the process according to the present invention to direct bio-printing of biological materials on biological substrates or non biological substrates, the manufactured devices can be biosensors devices, tissues engineering devices, regenerative tissues patches or DNA µ-arrays. In this case the receiving material is typically selected from paper sheet, glass, biological material films, flexible patches, petri dish, and the donor material is typically selected from DNA, skin cells, stem cells, proteins, tissues, etc.

The present invention is directed to a method of manufacturing a direct and selective surface deposition of a biological donor material onto a biological receiving material by a pulsed radiation treatment consisting of the following steps:
a) selecting a donor material in a solid state,
b) selecting a biological receiving material with a thickness down to 5 µm,
c) placing the donor material in a solid state on a spacer placed on the receiving material,
d) providing a pulsed radiation system able to transfer the donor material onto the receiving substrate material surface without any contact between said donor and receiving material,
e) applying the pulsed radiation of d) on the donor material in a solid state to transfer the metal donor material on the receiving material.

The implementation of this particular embodiment of the invention can provide for biosensors devices, regenerative tissue patches, DNA µ-arrays, etc.

Others applications of the present invention in the field of epoxy glass metallization by cupper for manufacturing glass interposer, in the field of metal-coated glass fibers and flakes production by the metallization of glass fiber and also in the field of metallization of optical fibers by a thin layer deposition of metal for bonding and soldering of said optical fiber.

The invention will now be described in more details by referring to the following non-limiting example.

### Example: Method of manufacturing selective surface metallization of silicon wafers by laser assisted deposition

The present example illustrates the method according to the present invention where the donor material (3) is aluminium and the receiving material (4) is silicon. The field of implementation of the invention is the photovoltaic solar cell manufacturing.

The problem to be solved in this particular field is the selective or whole plate metallization of silicon wafers surface in the field of photovoltaic solar cell manufacturing. Indeed, there are many processes to deposit metal onto silicon wafer such as screen-printing with aluminum pastes or inkjet structured with evaporated aluminum metallization (Mingirulli, N., PROC. 34th IEEE PVSC 1064-1068, 2009 - Fallisch, A., PROC. 35th IEEE PVSC, 3125 - 3130, 2010 - Mattle, T. et al., Appl. Surf. Sci. 258, p. 9352-9354, 2012). All these methods are neither direct nor simple to be set up. They are time and material consuming.

Here below are detailed the results of direct laser printing of A1 electrically conductive free shape patterns on thin mono and poly-crystalline silicon wafers (140 and 200 µm thick). The patterns created are lines, crosses and squares. We measured and compared the electrical performances (Rsheet, Conductivity, Resistivity, Mobility...) and mechanical properties (adhesion forces and volumes deposited) of this technique considering that we used different power densities, and different scan speeds. Scanning Electron Microscopy (SEM) pictures are taken for each case and it was demonstrated that the vicinities of the deposited metal are not thermally affected nor damaged. Combined with the Alicona 3D InfiniteFocus ® images, they revealed that the deposited areas dimensions can be: thick from 300 nm up to about 10 µm, large from 100 µm up to 2x2 cm². The SEM's EDX module confirmed that the sheet deposited are over 93 % in weight composed by aluminium: there is neither alloy nor oxide formed during the process. Standard scotch adhesion tests (3M™ Scotch-Weld™ Acrylic Adhesive 825) are successful. The Peel Strength at 22°C is 20 lb/inch (i.e. 350 g/mm). The first basic electrical tests, conductivities and Rsheet measurements, showed that the pattern can be used to conduct current: Rsheet are from 0.05 Ω/sq to 0.15 Ω/sq on all substrates (mono and poly crystalline silicon). Since this technique is maskless, operative in Normal Temperature and Pressure Conditions (NTPC) and cost effective, it can stand for a good alternative to classical metallization techniques.

### A. Raw material and experimental work

### Silicon wafers

As raw material, we used two main kinds of silicon wafers: poly-crystalline and mono crystalline from Cz growth method. The thicknesses that revealed not to be a major issue in the process were of 140 and 200 µm. Since the results in scope of our experimentation do not depend on the wafers thickness, we will only present the results obtained on 200 µm thick wafers.

### Laser and set-up

The forward transfer of the donor onto the wafer's surface by programming and implement the laser sequence (Mattle, T. et al., Appl. Surf. Sci. 258, p. 9352-9354, 2012.

For these experimentations we used an infrared-pulsed laser source. The wafers were placed in free atmosphere. The distance between the donor and the substrate has to be controlled since this can lead to optimizations to obtain the best metallization while avoiding the spreading of the pattern one wants to produce in that laser direct transfer process. Indeed controlling that distance helps to mitigate the effects of acoustic (Mattle, T. et al., Appl. Surf. Sci. 258, p. 9352-9354, 2012) wave generated in the small volume formed between the donor and the substrate. This stands for the major point in that method as the full and tight contact between the foil and the silicon in the method developed by Nedarka et al. is mandatory. At this time, this method (Nedarka, J-F., PROC. 25th EPSE Conference, 2010 - Nedarka, J-F., PROC. Manufacturing Issues and Processing; 28th EPVSEC 2013)doesn't seem to be useful for selective application and micro machining.

### Experimental key parameters

The major experimental parameters are detailed in Table 1:

**Table 1 : Key parameters description and their impact on the process**

| **Parameter** | **Parameter's type** | **Range** |
|---|---|---|
| Pressure | Environmental | Atmospheric |
| Temperature | Environmental | Ambient |
| Spacer thickness | Environmental | 15 to 100 µm |
| Scan speed | Environmental | 20 -100 mm/s |
| Pulse overlap | Laser | 75 to 95% |
| Wavelength | Laser | IR range |
| Pulse shape & diameter | Laser | Gaussian |
| Power | Laser | 0.7 to 4.5 W |

The following morphological and mechanical parameters have to be controlled: deposited surface & deposited thickness, line width and spaces between lines, laser impact threshold and heat affected zone and also adhesion.

The following morphological and mechanical parameters have to be controlled: metallic link or bound (transversal cut) and chemical composition.

The following electrical parameters have to be controlled: Rsheet, conductivity, charge mobility, resistivity.

### Patterns

We made different types of deposition on all the samples: lines, squares and crosses and free shape. These can serve as first point to identify all the possibilities offered by this method.

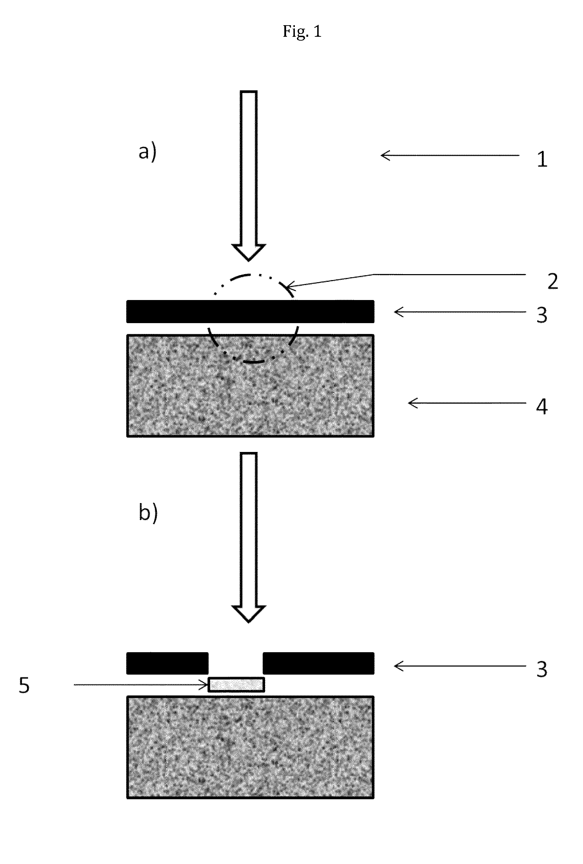

### Operating conditions (Fig. 1)

The process is based on the direct transfer of a metallic compounds onto a wafer. The basic phenomenon to be considered is linked with the heat dynamic. Heat dynamic can be related to the power, the overlapping rate, the space between the donor and the wafer and the scan speed. To simplify the operations we decided to keep constant some parameters values such as the scan speed, the frequency and the space between the donor and the silicon wafer. Said process is represented on Fig. 1.

All the following values come from measurements on the square pattern. These 1x1cm² surfaces are the ideal surface to provide for electrical and mechanical parameters values. We used the same laser each time and covered a wide range of laser power values at the same overlap rate of 70%. The scan speed was kept equal to 50 mm/s

### B. Results

### 1) Electrical measurement

The main goal of these experimentations and choice of a new method is to implement a way to metallize silicon wafers simply that can provide patterns for good electrical behavior. We come out to the point that in the field of the power tested from 0.75 to 5 W, all sample (squared one) were electrically conductive by the mean of a simple multimeter.

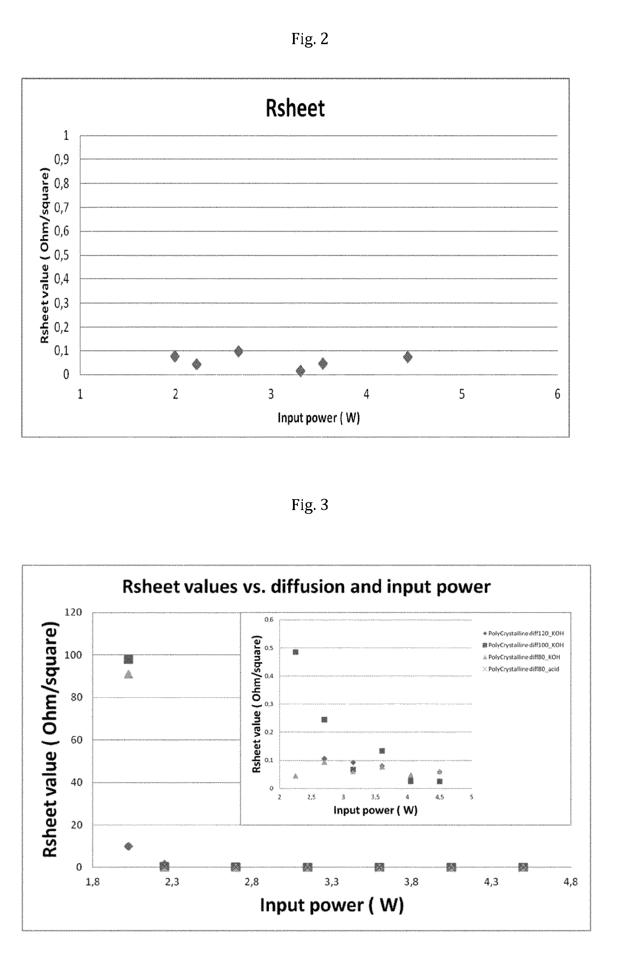

### Rsheet measurements (Fig. 2)

To go further, we also measured the Rsheet of all poly and mono crystalline square samples vs. the power used. To do so, we used a four points probes tool. Results are represented on Fig. 2 that shows Rsheet values versus power measured on square shaped metallized monocrystalline Si wafer for an overlap rate of 70%.

What is noticeable is the very low value measured (minimum= 0.05 Ω/sq). The window from 1.8 to 4.5W provides for repeatable low Rsheet values: very low resistant patterns that can be used for solar cells were produced.

### Conductivity measurements (Fig. 3)

We deposited A1 on poly crystalline silicon wafers with different dopings and texturations. The results are represented on Fig. 3 that shows Rsheet values versus power (W) measured on square shaped metallized poly-crystalline Si wafer.

All the Rsheet measured exhibit the same behaviour: there is a threshold value of power (2 W) after which the Rsheet values are decreasing to attain the values observed on the monocrystalline wafers.

### Hall effect values

Hall effects measurements were done on mono and poly crystalline samples with the same conditions to access the following measurements considering that the thickness of the Al "coating" is 10 µm. Results are presented in Table 2 below.

Metallization on mono-Si seems to be more conducive than on poly crystalline wafer but with less mobility.

**Table 2 : Hall effect parameters on square shaped A1 transferred on poly and mono silicon wafer**

| **Mean values** | **Mon crystalline** | **Poly Crystalline** |
|---|---|---|
| Conductivity (1/Ω.cm) | 1.4E04 | 2.07E3 |
| Mobility (cm²/Vs) | 3.33 | 6.38 |
| Resistivity (Ω.cm) | 7.11E-05 | 4.38E-05 |

### 2) Chemical and Metallurgical topography

### Chemical composition

We made several SEM-EDX analyses in the different configuration we had, all of them showed that when the transfer is good in term of aspect, the amount weight of A1 is huge. We found out that the minimum percentage in weight of Al in the composition of the deposited material is of 93% with traces of oxygen and carbone.

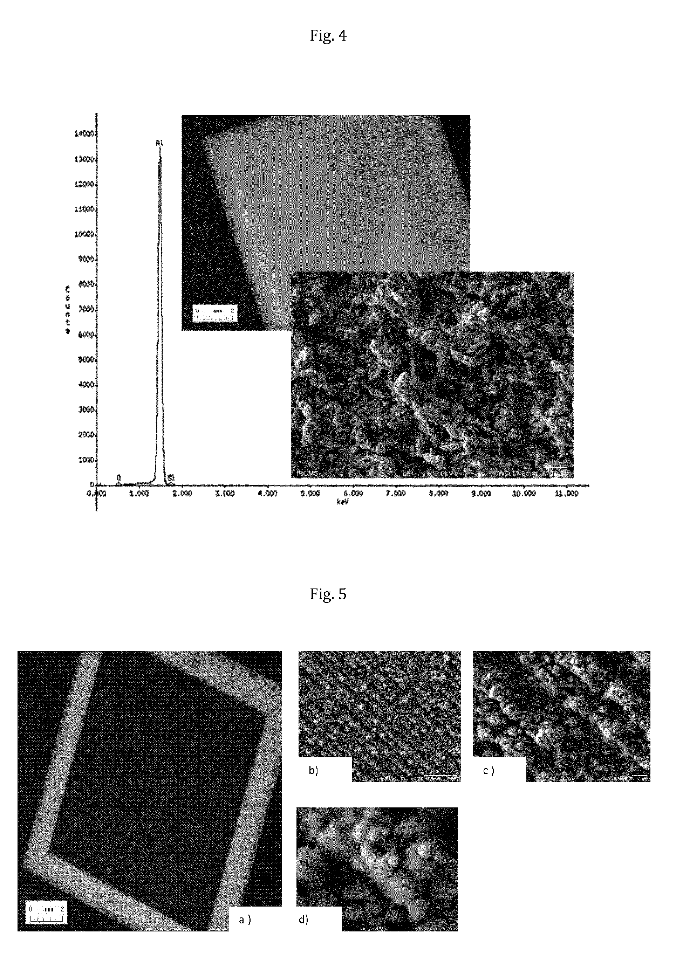

The results are represented on Fig. 4 that shows the EDX composition on square aluminium (Al) transferred on mono silicon wafer and pictures of that square and SEM details.

When there is a change in the overlapping rate from 70 to 85 % by only changing the frequency, a narrow window where we can observe a "black" transferred material appeared. It may be due to structures that diffract light and enable alloys formation. As described in Urrejola,E., PROC. 2nd Workshop on Metallization, 2010 and in Fig. 5, both are probably right. This may be explained by the phase diagram of the Al-Si alloy and it is also to be linked to the increase of the Rsheet value observed at the input power of 0.83 W just before the decrease where effectively, the composition is of the A1 almost alone.

Results are represented on Fig. 5 where the percentage of A1 is 12,98 the percentage of Si is 63,78 and the percentage of O is 23,24. Fig. 5 is a picture of A1 transferred on mono silicon wafer,SEM details and EDX analysis of the composition.
a) picture of the black "coating" at FP=0.83W and overlap=85%
b) detail of a) detailing the structures
c) and d) are details of b) detailing the structures

The transferred material is black due to the formation of an alloy between Al and Si, Al and O and also between Si and O. In presence we may find AlxOy, SixOy and AlxSiy. As a result of this section we can conclude that black aspect and eutectic composition can serve for two others applications of this patent:
a) creating black metallized silicon wafer for silicon based solar cells
b) doping silicon based solar cells since any material can be easily used and especially copper to metallize the silicon surface.

### 3) Morphology and mechanics

### Deposited surface and deposited thickness

Thanks to the ALICONA Infinite 3D™ optical microscope, we were able to measure on the whole laser treated surfaces of samples the mean values of the thickness of deposited Al. As described in Table 4 it appeared that the less thick shapes are lines. Knowing that we can easily make the process fit the thicknesses values as requested.

**Table 3: Mean values (µm) of thickness deposited sorted by wafers crystallinities and shapes deposited**

| **Mean value of the thicknesses by type of wafer and by shape** | **Mono crystalline** | **Poly-crystalline** |
|---|---|---|
| Square | 12.1 | 11.5 |
| Cross | 11.8 | 10.1 |
| Line | 3.5 | 2.1 |

### Laser impact threshold and Heat affected zone

The laser impact damage threshold has been determined as equal to 0.75 W when the overlap is 70% and the scan speed is 540 mm/s.

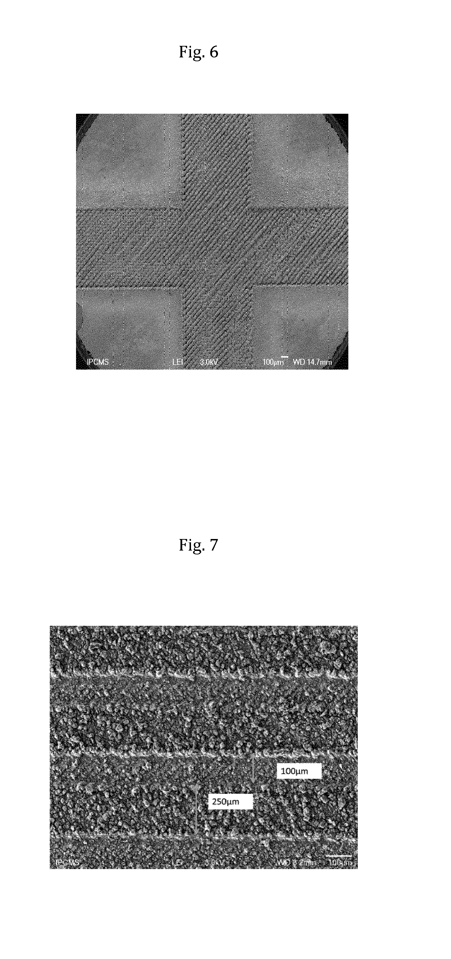

Fig. 6 represents a SEM image of the vicinity of A1 transfer on a poly-silicon wafer in shape of a cross.

As it can be seen on that SEM image, there is no affected zone. The silicon is preserved. The process also preserved in that condition the Rsheet on the wafer. Indeed, a mean value of 20 Ω/sq was measured on the wafer before and after the treatment in the vicinity of the cross.

### Line width and Spaces between lines

A series of lines of 200µm width with inter spaces of 100µm were made. For these first experimentations we did not focused on obtaining the best performances. The values cited are for what is relatively reproducible.

Fig. 7 represents SEM image Al lines transferred on mono silicon wafer.

Some best scores had been attained with patterns of 70µm width and spaces between of 100µm but the spreading was not so good.

### Adhesion

Thanks to simple measurements with 3M™ 850 scotch (that is a classic method used in many depositions tests (Nedarka, J-F., PROC. 25th EPSE Conference, 2010) the following simple test was made: we used the different squared transferred on poly and mono crystalline silicon and with a 30 mm long tape of scotch (3M™ Scotch-Weld™ Acrylic adhesive 825) we tried to peel of the transferred material from the silicon wafer. The tapes were weighted thanks to an Ohaus® Adventurer® analytical balance before and after the peeling and we found out a small mean difference (made on ten samples 5 poly crystalline and 5 mono crystalline wafers) of less than 2 mg which is not a noticeable nor a significant amount. Indeed we can consider that the removal rate is of 0.02 mg/mm² in this process.

### C. Conclusion

This example displays a direct process for free form metal (Al) deposition on mono and poly crystalline silicon thin wafers (200 µm). Using specific positioning and/or clamping tools and IR pulsed laser, we determined the parameter ranges (focalization, power, speed...) adapted and reliable for each form that enable to deposit, highly conductive (Rsheet less than 0.15 Ω/sq) adherent (0.02 mg/mm² loss of mass while performing a peeling test with the 3M™ Scotch-Weld™ Acrylic adhesive 825), stable metal composition patterns on mono and poly silicon wafers. We can also add that the performances of this process in terms of adhesion, composition stability and Rsheet are not time and environment dependent. Indeed, we included in the protocol to measure some samples on mono and poly silicon nine months later knowing they have not been specially protected from light and left at open atmosphere and at room temperature. These final measurements demonstrated the stability of the layers deposited as the values of compositions and Rsheet were the same.

It is understood that the present invention is capable of further modifications, uses and/or adaptations of the invention, following in general the principle of the invention and including such departures of the present disclosure as come within known or customary practice in the art to which the invention pertains, and as may be applied to the central features set forth herein, and are encompassed by the invention set forth in the following claims.

## Claims

1. Method of manufacturing a direct and selective surface deposition of a donor material (3) onto a receiving material (4) by a pulsed radiation (1) treatment consisting of the following steps:
a) selecting a donor material (2) in a solid state,
b) selecting a receiving material (4) able to receive a pulsed radiation treatment deposition,
c) selecting an adapted pulsed radiation (1) treatment that can both transfer the donor material (3) onto the receiving material (4) and in the meantime that can preserve the integrity of said receiving material (4),
d) placing the donor material (3) in a solid state on a spacer placed on the receiving material (4), without any contact between said donor (3) and receiving material (4),
e) applying the pulsed radiation (1) of c) on the donor material (3) in a solid state to transfer the donor material (5) on the receiving material (4).

2. Method according to claim 1, wherein the pulsed radiation (1) system is selected from a laser system or an electron beam system.

3. Method according to claim 1, wherein the donor material (3) in a solid state is selected from a foil, a wire, a ribbon or a gel film.

4. Method according to claim 3, wherein the donor material (3) is selected from a plastic and/or a polymer, a metal or a metal alloy, a biological material, a graphene or a silicon carbide sheet.

5. Method according to claim 4, wherein the donor material (3) is a metal donor selected from a metal or a metal alloy.

6. Method according to claim 4, wherein the donor material (3) is selected from plastic material or polymer material.

7. Method according to any of claims 1 to 6, wherein the receiving material (4) has a planar or a three-dimensional surface to receive the donor deposition.

8. Method according to claim 1, wherein the receiving material (4) is selected from a semi-conductor, plastic or polymer, textile, glass, paper, graphene and graphene related materials, ceramic, wood, acetate or Nafion®.

9. Method according to claim 8, wherein the receiving material (4) is selected from silicon, silicon related materials and silicon oxides.

10. Method according to any of claims 1 to 9, wherein the donor material (3), the spacer and the receiving material (4) are hold by a mechanical clamping system.

11. Method of manufacturing a direct and selective surface deposition of a metal donor material (3) onto a receiving material (4) by a pulsed radiation (1) treatment consisting of the following steps:
a) selecting a metal donor material (3) in a solid state,
b) selecting a receiving material (4) able to receive a pulsed radiation treatment deposition,
c) selecting an adapted pulsed radiation (1) treatment that can both transfer the donor material (3) onto the receiving material (4) and in the meantime that can preserve the integrity of said receiving material (4),
d) placing the metal donor material (3) in a solid state on a spacer placed on the receiving material (4) without any contact between said donor (3) and receiving material (4),
e) applying the pulsed radiation (1) of c) on the donor material (3) in a solid state to transfer the metal donor material (5) on the receiving material (4) surface.

12. Method according to claim 11, wherein the pulsed radiation (1) system is a laser system.

13. Method according to any of claims 11 or 12, wherein the metal donor material (3) is selected from aluminium or aluminium alloys, bismuth or bismuth alloys, chromium or chromium alloys, cobalt or cobalt alloys, copper or copper alloys, gallium or gallium alloys, gold or gold alloys, indium, iron or iron alloys, lead or lead alloys, magnesium or magnesium alloys, mercury or mercury alloys, nickel or nickel alloys, potassium or potassium alloys, silver or silver alloys, sodium or sodium alloys, titanium or titanium alloys, tin or tin alloys, zinc or zinc alloys, zirconium or zirconium alloys, graphene and its related materials or silicone carbide and its related materials.

14. Method according to any of claims 11 to 13, wherein the receiving material (4) is selected from semi-conductors, plastics or polymers, textiles, glasses, papers, graphene and graphene related materials, ceramics, acetates or Nafion®.
